# EUROPEAN PATENT APPLICATION

(11) **EP 4 601 429 A1**
(43) Date of publication of application: **13.08.2025**
(21) Application number: 25155666.8
(22) Date of filing: 03.02.2025
(51) Int. Cl.: H05K 7/20

(54) **ZONE-BASED THERMAL MANAGEMENT OF INTERIOR SPACES VIA REAL TIME COMPUTATIONAL FLUID DYNAMICS (CFD) MODELING**

(30) Priority: 09.02.2024 US 202463551671 P; 27.01.2025 US 202519037410
(71) Applicant: Vertiv Corporation, Westerville, OH 43082 (US)
(72) Inventor: Ratcliff, Gregory W., Westerville, 43082 (US)
(74) Representative: Cousens, Nico

(57) **Abstract**

A system and method for thermal management of a data center or like environment provides parameters including a dimension set of the environment, an equipment configuration of servers or other IT devices operating within the environment, a computer room air conditioner (CRAC) configuration of CRAC units operating within the environment, and a policy set defining zones within the environment and required environmental conditions (e.g., temperature, humidity) for each zone. A CRAC control loop or like controller generates an environmental model of the environment based on these parameters and infers current environmental conditions on a zone-by-zone basis. If, for example, inferred conditions in one or more zones sufficiently deviate from, or trend toward deviation from, the required conditions for said zones, the controller may adjust one or more CRAC setpoints to maintain said zones within required temperature and/or humidity ranges.

## Description

### CROSS-REFERENCE TO RELATED APPLICATIONS

The present application claims the benefit under 35 U.S.C. § 119(e) of U.S. Provisional Patent Application Serial Number 63/551,671 filed February 9, 2024, titled SYSTEM AND METHOD FOR THERMAL MANAGEMENT OF INTERIOR SPACES VIA REAL TIME COMPUTATIONAL FLUID DYNAMICS (CFD) MODELING.

### TECHNICAL FIELD

The present disclosure is directed generally to the field of thermal management for data centers and other enclosed or interior spaces, and particularly to modeling of environmental conditions within said spaces.

### BACKGROUND

When controlling a data center, computer room, or similar enclosed space within which computing loads (and consequently power usage) constantly vary, maintaining optimal temperature and humidity is essential to prevent overheating of, and damage to, computer equipment. However, all computer rooms are not created equal. Room dimensions, server and computer equipment arrangements, and the placement and capacity of computer room air conditioners (e.g., CRAC units) may vary greatly from space to space. Further, each piece of computer equipment and each piece of cooling equipment may have its own set of specifications (e.g., with respect to power usage, heat generated as a result of power usage, cooling capacity). Further, due to these factors, temperature and humidity may vary throughout a given computer room; for example, portions of the room closer to CRAC units may be more easily maintained than portions distant from the CRAC units, or where direct flow of cooler air may be obstructed by pillars, walls, or other fixtures.

In order to maintain the computer room within a required temperature range, it may be necessary to deploy an excessive amount of air conditioning resources in order to ensure that heat generated in remote parts of the room is circulated out of the room. This conservative approach to thermal management may succeed in maintaining the temperature ranges required, but at great expense in terms of resource deployment and power usage. Further, even where it is understood that cooling needs may vary throughout a room, the process of understanding the dynamics of airflow given a particular computer room and a particular configuration of servers and air conditioners is non-trivial. For example, a configuration of servers and CRAC units within a computer room may only be calibrated and tested by real-world physical implementation of the configuration and the deployment of numerous temperature sensors throughout the configured computer room for observation over time. Further, the more precise and granular the portrait of airflow and temperature conditions desired (e.g., the more sub-volumes the room can be represented as, and the smaller each individual sub-volume), the more sensors must be deployed. For any significant change to this configuration, e.g., the addition, removal, replacement, or repositioning of any server or CRAC unit, the sensors must be reinstalled and the calibration process restarted to accurately map any resulting changes in airflow and temperature conditions.

### SUMMARY

In a first aspect, a computer-assisted method for thermal management within a data center or like environment is disclosed. In embodiments, the method includes receiving a dimension set of physical dimensions of the data center. The method includes receiving an equipment configuration including the positions and thermal outputs of any servers, switches, or other heat generating information technology (IT) devices operating within the data center. The method includes receiving a computer room air conditioner (CRAC) including the positions and setpoints (e.g., outlet temperature, airflow rate) of CRAC units providing thermal management of the data center by circulating chilled air therethrough. The method includes receiving a policy set defining zones within the data center and any environmental requirements (e.g., temperature and/or humidity ranges) specific to each zone. The method includes generating, based on the received parameters, an environmental model of the data center mapping environmental conditions within the data center based on combinations of operating parameters. The method includes inferring current environmental conditions (e.g., temperature, humidity) within one or more specific zones based on the environmental model (e.g., IT devices operating within a zone and current setpoints of CRAC devices operating within said zone). The method includes comparing the inferred conditions to environmental requirements for a given zone or zones. The method includes, when inferred conditions in a zone or zones sufficiently deviate from, or trend toward deviation from, environmental requirements for that/those zone/s, adjusting CRAC device setpoints to maintain the zone/s within required environmental ranges.

In some embodiments, the method includes verifying the environmental model via temperature or humidity sensors within the data center or specific zone/s thereof.

In some embodiments, the method includes generating the environmental model according to lattice Boltzmann methods.

In some embodiments, the method includes, when inferred conditions within a zone or zones deviate to at least a threshold level from required conditions for that/those zone/s, generating an alert.

In some embodiments, the CRAC configuration is a hypothetical CRAC configuration, and the method includes inferring hypothetical environmental conditions within a zone or zones based on the hypothetical CRAC configuration.

In some embodiments, the method includes receiving an equipment change to the equipment configuration, associated with an addition or removal of IT devices to or from the environment, an activation or deactivation of IT devices within the environment, or a repositioning or reorientation of IT devices within the environment.

In some embodiments, the method includes receiving a CRAC change to the CRAC configuration, associated with an addition or removal of a CRAC unit to or from the environment, an activation or deactivation of a CRAC unit within the environment, or a repositioning or reorientation of CRAC units within the environment.

In some embodiments, required environmental conditions for a particular zone include a required temperature range, a required humidity range, or a required airflow rate; similarly, inferred environmental conditions include an inferred temperature, humidity, or airflow rate.

In some embodiments, the equipment configuration accounts for obstacles within the environment, such as objects (other than IT devices or CRAC units) that obstruct or redirect airflow through the environment. For example, the equipment configuration notes the position of each obstacle.

In some embodiments, CRAC setpoints include an output air temperature (e.g., of chilled air leaving the CRAC unit) or an output flow rate (e.g., a fan setting for chilled air leaving the CRAC unit).

In some embodiments, CRAC units include sensors for determining the output air temperature, a return air temperature of air returning to the CRAC unit from the environment, and/or a fan setting of the CRAC unit.

In some embodiments, the CRAC configuration is updated based on sensed output air temperature, sensed return air temperature, and/or sensed fan setting.

In some embodiments, one or more IT devices includes a sensor for sensing heat generated by, or the thermal output of, the IT device. For example, the equipment configuration may be updated based on the sensed thermal output of one or more IT devices.

In embodiments, the controller receives an ambient temperature and/or ambient humidity sensed outside (e.g., but proximate to) the environment. For example, the environmental model may account for, or may be updated to include, ambient temperature or humidity sensed outside the environment.

In embodiments, the ambient temperature or ambient humidity is an estimate provided by the dimension set, the policy set, or the equipment configuration.

In a further aspect, a system for thermal management of an environment, e.g., via a computer room air conditioner (CRAC) control loop, is disclosed. In embodiments, the system includes processors and memory for storing: a set of the physical dimensions of the environment (e.g., data center room); an equipment configuration indicating the arrangement and specifications of information technology (IT) devices (e.g., servers, switches) within the environment, where each IT device has a relative position in the environment and a known or measurable thermal output; a CRAC configuration of CRAC units disposed at relative positions within the environment, e.g., to remove heat therefrom by circulating chilled air through the environment, where each CRAC unit has one or more adjustable setpoints to control the air cooling and circulation; and a policy set dividing the environment into zones and defining temperature and/or humidity requirements (e.g., required range, maximum temperatures, maximum humidity) for each zone. In embodiments, based on the dimension set, equipment configuration, and CRAC configuration, the CRAC control loop models in detail the environment and conditions therein, e.g., expected airflow, expected cooling capacity, expected temperature and/or humidity by zone and throughout the environment. Based on this detailed model of the environment and its component devices, the CRAC control loop can infer environmental conditions on a zone-by-zone basis without having to directly sense real-world conditions. The CRAC control loop compares inferred conditions to required conditions as outlined in the policy sets. If, for example, the inferred temperature in a given zone sufficiently deviates, or trends toward deviation, from the required temperature range within that zone, the CRAC control loop may adjust CRAC setpoints individually or as a group to counter the deviation.

In some embodiments, the environmental model is generated according to lattice Boltzmann methods.

In some embodiments, the system includes calibration sensors for verifying or updating the environmental model. For example, calibration sensors may collect real time air temperature or humidity readings to confirm the inferences of the environmental model or in response to which the model may adjust and evolve.

In some embodiments, the system includes external sensors outside the environment proper. For example, external sensors may augment the environmental model (or contributing components thereof, such as the equipment configuration) with ambient temperature and/or humidity readings.

This Summary is provided solely as an introduction to subject matter that is fully described in the Detailed Description and Drawings. The Summary should not be considered to describe essential features nor be used to determine the scope of the Claims. Moreover, it is to be understood that both the foregoing Summary and the following De-tailed Description are example and explanatory only and are not necessarily restrictive of the subject matter claimed.

### BRIEF DESCRIPTION OF THE DRAWINGS

The detailed description is described with reference to the accompanying figures. The use of the same reference numbers in different instances in the description and the figures may indicate similar or identical items. Various embodiments or examples ("examples") of the present disclosure are disclosed in the following detailed description and the accompanying drawings. The drawings are not necessarily to scale. In general, operations of disclosed processes may be performed in an arbitrary order, unless otherwise provided in the claims. In the drawings:
FIG. 1 is a diagrammatic illustration of a thermally managed interior space according to example embodiments of the inventive concepts disclosed herein;
FIG. 2 is a block diagram of a thermal management system for the interior space of FIG. 1; and
FIGS. 3A through 3E are flow diagrams illustrating a computer-assisted method for thermal management within a data center or like enclosed space according to example embodiments of the inventive concepts disclosed herein.

### DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "some embodiments" means that a particular element, feature, structure, or characteristic described in connection with the embodiment is included in at least one embodiment disclosed herein. The appearances of the phrase "in some embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

Broadly speaking, embodiments of the inventive concepts disclosed herein are directed to a system and computer-assisted method for non-sensor-dependent thermal management within a data center or other appropriate enclosed space via real time computational fluid dynamics (CFD) modeling. For example, by modeling temperature, humidity, airflow, and other environmental conditions within the data center in real time, environmental control systems may be rendered more efficient by being to operate not only responsively but proactively with respect to uninterrupted maintenance of the enclosed space at a required temperature and/or humidity. Further, a chilling/air conditioning system installed within the enclosed space may adapt to changes within the space without the need for technicians to manually recalibrate the system; rather, the chilling system may adjust to changes in fluid dynamics naturally.

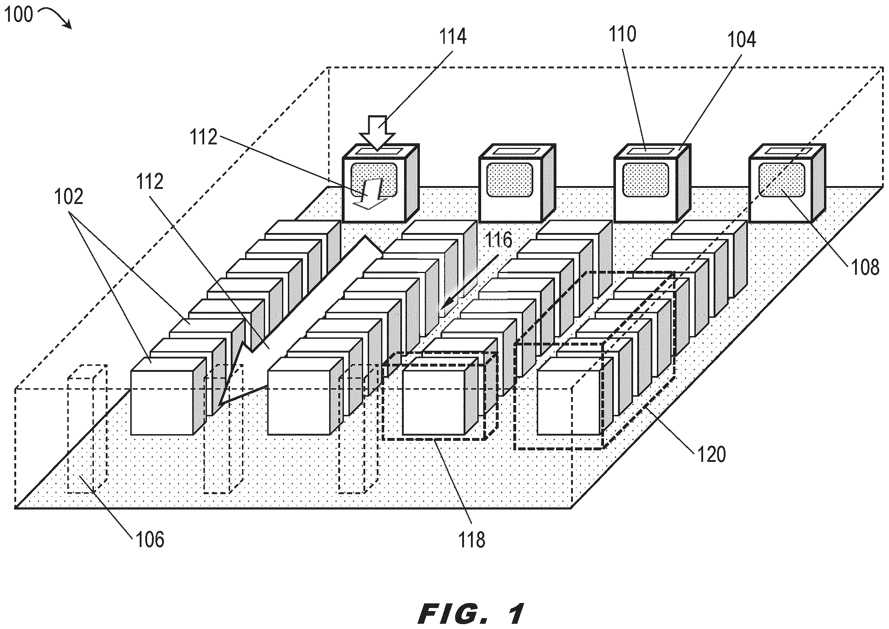

Referring to FIG. 1, a data center 100 is shown. The data center 100 may include servers 102 or any other appropriate heat-generating devices, chiller devices 104 (e.g., computer room air conditioner (CRAC) units), and obstacles 106.

In embodiments, the data center 100 may comprise an enclosed room within which a predetermined number of servers 102 or like devices may operate, each server operating continuously and dissipating its operating power into heat. Accordingly, where a large number of servers 102 are arranged together in a compact space such as the data center 100, the resulting heat must be expediently removed from the space in order to prevent breakdown of and/or damage to the servers. In embodiments, CRAC units 104 may be positioned within the data center 100 to circulate chilled air through the enclosed space and remove any generated heat (and/or humidity) from the space in order to maintain the data center within optimal temperature and humidity ranges for uninterrupted operation of any servers 102 within. For example, each CRAC unit 104 may include one or more air outlets 108 and one or more air returns 110. In embodiments, CRAC units 104 may emit chilled air 112 from each air outlet 108, e.g., at a predetermined orientation and/or direction. The chilled air 112 circulates through the data center 100, and heat and/or humidity generated by the servers 102 is directed as return air 114 to the air returns 110 of each CRAC unit 104. Return air 114 may be chilled within the CRAC units 104 (e.g. air cooling, water cooling, and/or any other appropriate means of heat transfer); the chilled air 112 is reintroduced into the data center 100 and the excess heat transferred away from the data center. In some embodiments, a CRAC unit 104 may include onboard sensors for sensing and reporting an actual output air temperature of the chilled air 112 released into the data center 100, a return air temperature of the return air 114 entering the CRAC unit, and/or a setting associated with a fan or blower of the CRAC unit (e.g., fan speed).

In embodiments, ensuring that the data center 100 is maintained continually within optimal temperature and/or humidity ranges depends on a combination of controllable factors. For example, the servers 102 may be arranged within the data center 100 in such a way that heat dissipated by the servers escapes into aisles 116 or other corridors and spaces through which chilled air 112 may circulate freely. Further, the servers 102 may be arranged so as to allow airspace overhead into which warmer air may rise and circulate into the air returns 110. Further still, each CRAC unit 104 may incorporate selectable setpoints determining a target temperature and airflow rate of chilled air 112 introduced into the data center 100.

Conventional approaches to thermal management provide that, given an arrangement of servers 102 within the data center 100, and a given number of CRAC units 104 each set to emit chilled air 112 at a particular airflow rate and a particular air temperature, the data center can be maintained within required temperature ranges on an uninterrupted basis. However, environmental conditions within the data center 100 may conventionally only be verifiable through a network of sensors distributed throughout the data center: the more precise a snapshot of environmental conditions within the data center is desired, the more sensors (more accurate, more expensive) sensors are needed. If changes are made within the data center 100 that affect airflow through the interior space (e.g., addition, removal, or repositioning of servers 102, addition, removal, or repositioning of CRAC units 104), technicians must first test and calibrate the CRAC units 104, and observe the changes in environmental conditions resulting from any physical reconfigurations, before the data center 100 goes online in order to prevent unforeseen interruptions in service.

In embodiments, obstacles 106 may be placed throughout the data center 100. For example, obstacles 106 may not be heat-generating devices, but may include support structures, furniture or fixtures, or any other structure within the data center 100 (e.g., that may not be removed or repositioned) capable of obstructing or affecting the flow of air through the data center, and that must therefore be accounted for in any assessment of environmental conditions within the data center.

In embodiments, optimal thermal management within the data center 100 may provide for precise, targeted cooling of individual zones 118, 120 within the data center rather than attempting to maintain a uniform temperature throughout the space. For example, zones 118, 120 may include physical or virtual regions within the data center, e.g., a zone 118 corresponding to the space surrounding a particular server 102, a zone 120 corresponding to a region of the data center, a virtual zone comprising a set of non-contiguous airspaces or volumes within the data center. For example, a conservative approach to thermal management may include establishing a uniform maximum temperature throughout the data center 100 and operating the CRAC units 104 with the goal of uninterrupted maintenance of the maximum temperature throughout the data center. However, due to the flow of air, chilled air 112 and return air 114, throughout the data center 100, actual environmental conditions (e.g., air temperature in a particular zone 118, 120) may vary widely. For example, servers 102 directly in the path of chilled air 112 output by the CRAC units 104 may be more easily maintained at a target maximum temperature than servers at the opposite end of the data center 100, where the airflow may be partially obstructed or directed in counterintuitive ways. Accordingly, optimal thermal management according to the inventive concepts disclosed herein may aim to minimize energy consumption by setting policy for thermal management in each of a collection of zones 118, 120 throughout the data center 100 rather than for the airspace of the data center as a uniform whole.

Embodiments of the inventive concepts disclosed herein are directed to a method and system for modeling environmental conditions within the data center 100 on a real time or near real time basis via computational fluid dynamics (CFD) and operating CRAC units 104 within the data center via a control loop that adapts the setpoints of one or more CRAC units based on current environmental conditions within the data center (as modelled by the system) and environmental requirements for the data center, e.g., required ranges for temperature and/or humidity within which the data center must be maintained on an uninterrupted basis.

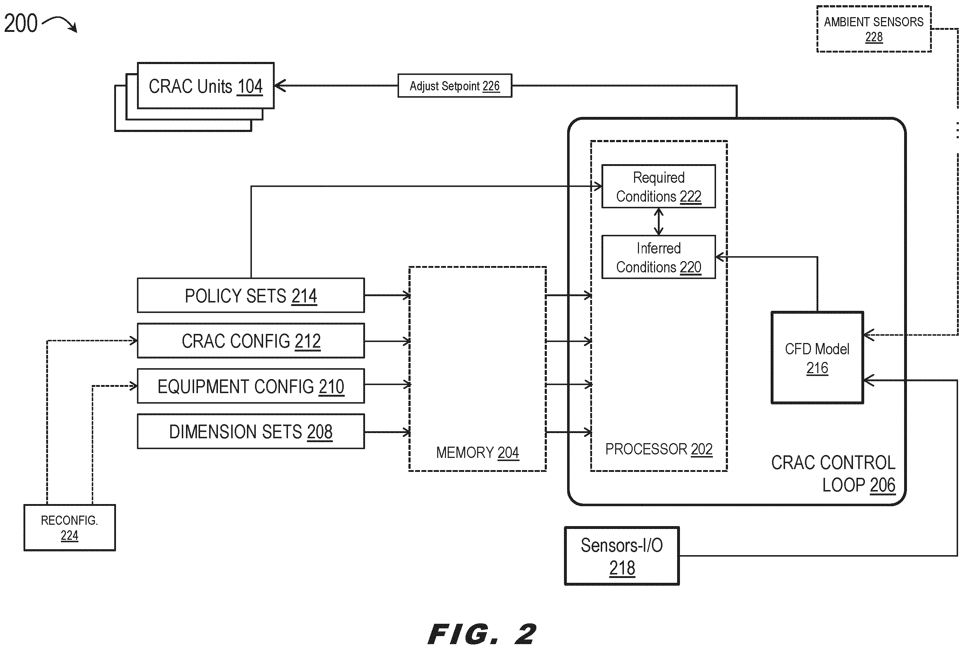

Referring now to FIG. 2, a system 200 for environmental modeling is shown. In embodiments, the system 200 may be configured for execution in a parallel processing environment, the parallel processing environment part of a control loop for adjusting output air temperature, output air flow, and other applicable CRAC unit (104, FIG. 1) setpoints based on a current state of environmental conditions within the data center (100, FIG. 1) as modelled by the system and as compared to required environmental conditions for the data center. Accordingly, the system 200 may include one or more processors 202 and a memory 204 or other appropriate data storage (e.g., solid-state, cloud-based) configured for storage of one or more of the inputs and/or models disclosed below (which alternatively may be incorporated into the CRAC control loop 206).

In embodiments, the system 200 may receive as inputs a dimension set 208, equipment configuration 210, CRAC configuration 212, and policy sets 214. Further, in embodiments the CRAC control loop 206 may monitor and adjust any setpoints for each CRAC unit 104 as well as any CRAC unit sensors, e.g., output air sensors disposed at or proximate to the air outlets 108 for sensing actual temperature of chilled air 112 output into the data center, and/or return air sensors disposed at or proximate to the air returns 110 for sensing the temperature of return air 114 entering the CRAC unit from within the data center 100 (e.g., as the differences between return-air and output-air temperatures are indicative of the device's effective cooling capacity). For example, the CRAC control loop 206 may control the operations of CRAC units 104 individually or in groups based on temperature and/or humidity requirements provided for by policy sets 214 established by the owners/administrators of the data center 100.

In embodiments, the dimension set 208 may define in detail the physical dimensions of the data center 100 and the volume it encloses, e.g., length, width, and height of the data center room/s. It is generally expected that the dimension set 208 may be fixed, although the configuration of servers 102 and/or CRAC units 104 within the data center may vary as noted below. In some embodiments, the dimension set 208 may update dynamically based on, e.g., opening or closing of doors or other factors that may affect airflow throughout the data center 100.

In embodiments, the equipment configuration 210 may define the set of servers (102, FIG. 1) and other like heat-generating information technology (IT) devices (e.g., switches) configured for operation within the data center 100, e.g., the positions of each server within the data center, power requirements of each server, thermal output of each server. For example, the equipment configuration 210 may estimate or infer the thermal output of each server 102 based on, e.g., the specifications of the server and/or its placement within the data center 100. In some embodiments, one or more servers 102 may include onboard sensors for sensing and reporting thermal output periodically or in real time, and thus the equipment configuration 210 may dynamically update with respect to the sensed thermal output of some or all of the servers included therein.

In embodiments, the CRAC configuration 212 may define the set of CRAC units 104 to be deployed for thermal management within the data center 100, e.g., the cooling capacity of each CRAC unit, applicable unit setpoints (e.g., output flow rate, output air temperature), the positions of each CRAC unit within the data center and the orientations of its air outlets (108, FIG. 1) and air returns (110, FIG. 1). In some embodiments, the CRAC configuration 212 may update dynamically based on output air temperatures, return air temperatures, and/or fan and blower settings sensed and reported by one or more deployed CRAC units 104.

In embodiments, policy sets 214 may define a set of zones (118, 120; FIG. 1) throughout the data center 100 (e.g., such that every region of the data center is associated with at least one zone) and establish specific required environmental conditions (e.g., maximum temperature and/or required operating temperature range) for optimal thermal management within each zone.

In embodiments, the system 200 may generate a computational fluid dynamics (CFD) model 216 of the data center 100 based on the above inputs. For example, the CFD model 216 may simulate fluid densities throughout the data center 100 according to lattice Boltzmann methods (or other appropriate means for modeling CFD in real time with comparable processing power) based on, e.g., the movement of heat dissipated from the servers 102 arranged within the data center and the introduction of chilled air (112, FIG. 1) by each CRAC unit (104, FIG. 1) at current outlet air temperature and outlet airflow setpoints, the placement of obstacles (106, FIG. 1) within the data center, and the effectiveness of the CRAC units as indicated by the sensed return air temperature of return air (114, FIG. 1) returning to the CRAC units.

In embodiments, the CFD model 216 may comprise a model, in real time or near real time, of airflow through the data center 100, including heated air dissipated by the servers 102, chilled air 112 introduced by the CRAC units 104, and return air 114 recirculating to the CRAC units from within the data center. Accordingly, the CFD model 216 may likewise infer the temperature and/or humidity of circulating air within specific zones 118, 120, sub-zones within zones, and/or points (e.g., a point being a minimally sized zone) within the data center 100 as opposed to directly sensing temperature and humidity via a dense network of sensors.

In embodiments, the CFD model 216 may be associated with an initial or calibration phase, whereby the model of temperature, humidity, and other environmental conditions within the data center 100 is verified and/or adjusted based on direct temperature/humidity sensing via sensors 218. For example, once the CFD model 216 is sufficiently calibrated, e.g., to a threshold level, with respect to the accuracy of the model, the system 200 may enter an operational phase where the CRAC control loop 206 compares, for any given zone 118, 120, inferred temperature and/or humidity 220 (or other like environmental conditions) based on the CFD model 216 with temperature or humidity requirements 222 (e.g., required ranges) for that zone provided for by the policy sets 214. For example, the system 200 may determine that the CRAC units 104 within a particular zone 120 are performing as expected (e.g., based on an inferred temperature and/or humidity 220 within the ranges 222 required by the policy sets 214). Alternatively, the system 200 may determine that inferred temperature and humidity 220 within the zone 120 based on the CFD model 216 are currently within the required ranges 222, but may be trending toward deviation, e.g., inferred temperatures within the zone are nominal but trending upward. Accordingly, the system 200 may direct the CRAC control loop 206 to adjust (226) the setpoints of one or more CRAC units 104 within the zone 120, e.g., to lower the temperature of chilled air 112 entering the zone or increase the rate at which chilled air enters the zone. Further, in some embodiments (e.g., if reconfigurations 224 (or dynamic updates, as described above) are made to one or more of the equipment configuration 210 or the CRAC configuration 212) the inferred temperature/humidity 220 within the zone 120 based on the CFD model 216 may deviate from required ranges 222 for that zone provided by the policy sets 214 to at least a threshold level despite adjustments 226 to the CRAC setpoints by the CRAC control loop 206, at which point the system 200 may generate an alert indicative of a need for further reconfiguration.

In embodiments, reconfigurations 224 may include adjustments of, or revisions to, one or more of the equipment configurations 210 or the CRAC configuration 212. For example, one or more servers 102 within the data center 100 may be replaced with other servers having different specifications. More generally, reconfigurations 224 may provide that servers 102 are added to the data center 100, removed from the data center (and, e.g., replaced with other servers or IT devices having different specifications and/or capacities), activated or deactivated within the data center, or repositioned within the data center. Similarly, CRAC units 104 may be replaced, added to, removed from, activated or deactivated within, or repositioned within the data center 100. Any of these reconfigurations 224 or dynamic updates may affect or alter the circulation of airflow within the data center 100 (or specific zones 118, 120 thereof) and accordingly may influence or alter the CFD model 216. For example, as noted below, the effect or one or more reconfigurations 224 on environmental conditions within the data center 100 or within specific zones 118, 120 thereof may be modeled prior to any physical changes being made within the data center, in order to understand their effects on thermal management. Alternatively, one or more reconfigurations 224 may be made within the data center 100, and the CFD model 216 allowed to adapt or recalibrate to new equipment and/or CRAC configurations 210, 212 and to adjust (226) CRAC unit setpoints as needed. For example, neither the system 200 nor the CFD model 216 need know the precise nature of any reconfigurations 224 or dynamic updates associated with the servers 102 or CRAC units 104. Rather, the CFD model 216 may account for any airflow, temperature, or humidity changes throughout the data center 100 as they occur, adjusting (226) CRAC setpoints accordingly or generating an alert if the revised CFD model cannot be made to converge with required temperature and/or humidity ranges 222.

In some embodiments, the CFD model 216 may be generated based on one or more hypothetical components, e.g., a hypothetical dimension set 208, equipment configuration 210, and/or CRAC configuration 212. For example, based on one or more hypothetical components, the CFD model 216 may predict environmental conditions within the data center 100 or within particular zones 118, 120 thereof, eliminating the need to physically test the hypothetical conditions to determine whether the required environmental conditions may be maintained. Further, the CFD model 216 may be used to determine an optimal positioning of a given number of servers 102 and/or CRAC units 104 within a data center 100 of given dimensions without the time and expense needed to physically test even one such positioning.

In some embodiments, the CFD model 216 may include ambient temperature or humidity conditions external to the data center 100 and collected by ambient sensors 228. For example, if the data center 100 is located in a temperate region, outdoor temperature and humidity may vary throughout the year, affecting power usage, CRAC unit wear and tear, and other factors associated with the maintenance of required environmental conditions inside the data center as provided for by the policy sets 214.

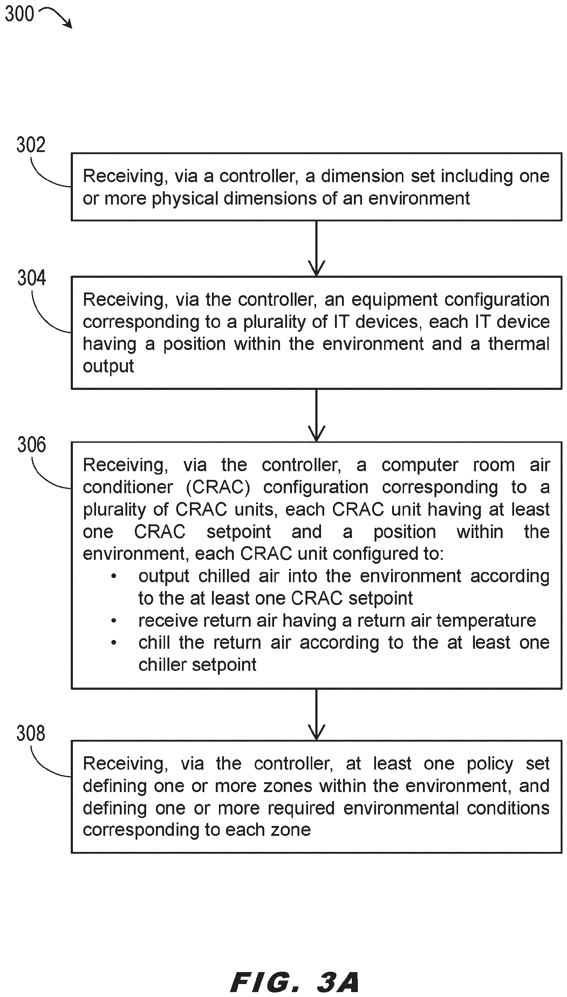

Referring now to FIG. 3A, a computer-assisted method 300 for thermal management within a data center, computer room, or any like appropriate environment may be implemented by the system 200 and may include the following steps.

At a step 302, the system receives a dimension set for the room, e.g., height, width, length, volume.

At a step 304, the system receives an equipment configuration whereby a set of servers, computer equipment, and/or like heat generating devices is configured within the room, each device having a specific position relative to the room and a known thermal output. In some embodiments, one or more devices may include onboard sensors for dynamically sensing and reporting thermal output.

At a step 306, the system receives a computer room air conditioner (CRAC) configuration whereby a set of CRAC units is configured within the room, each CRAC unit at a particular position relative to the room and configured, via adjustable setpoints, to circulate air through the room, collecting warmer return air from within the room, chilling the return air according to the setpoint/s, and returning the chilled air to the room.

At a step 308, the system receives policy sets defining zones or sub-volumes/sub-spaces within the room, as well as required environmental conditions (e.g., maximum temperature, temperature range, humidity) to be maintained throughout each zone.

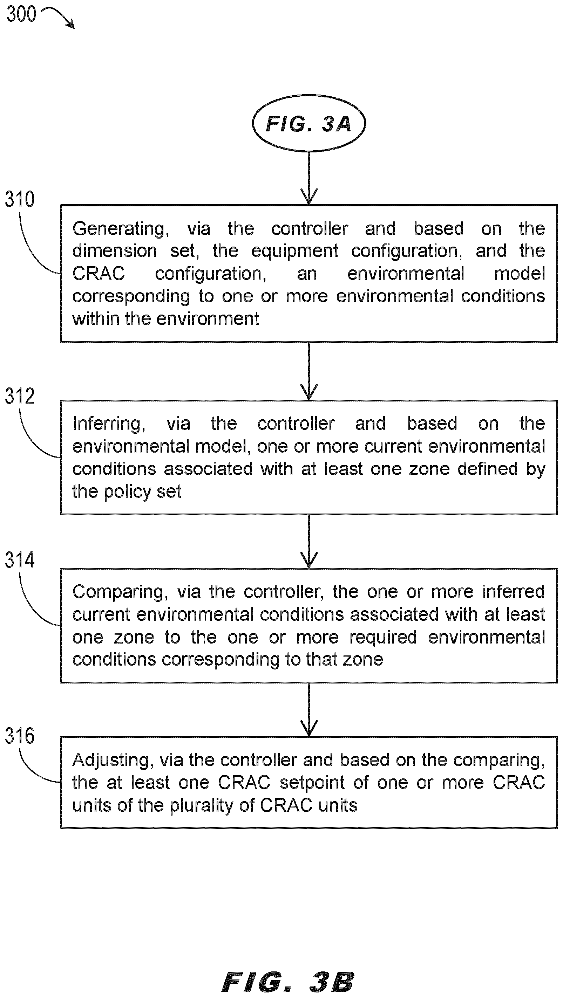

At a step 310, referring also to FIG. 3B, the system generates an environmental model mapping environmental conditions (e.g., temperature patterns, airflow, humidity) throughout the airspace based on the dimension set and the equipment and CRAC configurations. For example, the environmental model may map the thermal output of each server device and the cooling capacity of each CRAC unit to circulate chilled air throughout the room and return warmer air to the CRAC units for recooling. In some embodiments, the environmental model may be based on hypothetical configurations of computer equipment and CRAC units at specific relative positions within the room.

At a step 312, the system infers, based on the environmental model, current environmental conditions within one or more zones defined by the policy sets. For example, as the environmental model can map or predict airflow and temperature throughout the room, the conditions at specific zones within the room may also be inferred based on their relative locations within the room.

At a step 314, inferred environmental conditions within a particular zone may be compared to required environmental conditions for that zone, e.g., a temperature range within which the zone must be maintained.

At a step 316, one or more CRAC unit setpoints may be adjusted based on the comparing. For example, if the comparing shows that temperatures are trending outside the required range in a particular zone, one or more CRAC units near that zone may be adjusted for lower output air temperature or higher output air flow rate.

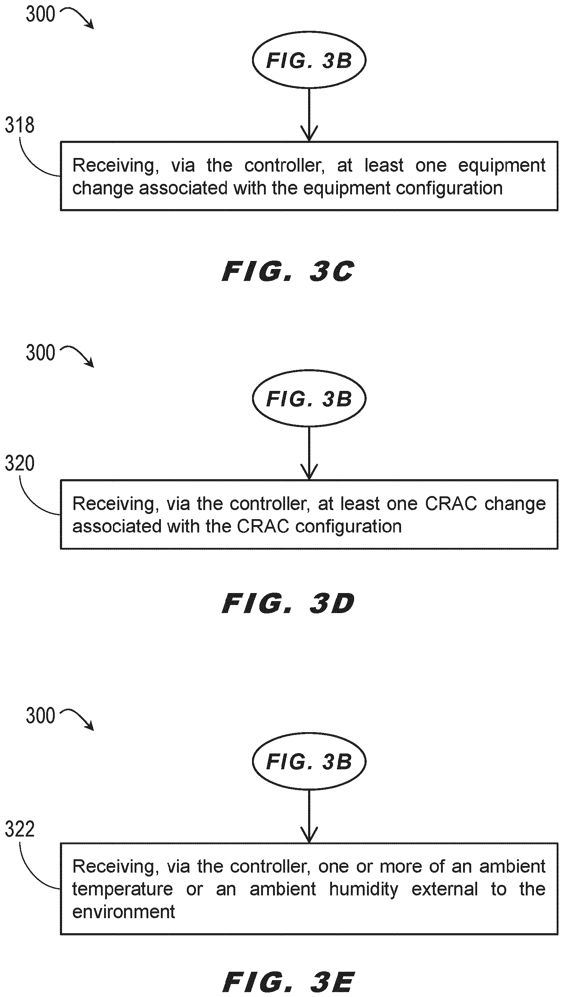

Referring now to FIG. 3C, the method 300 may include an additional step 318. At the step 318, the system receives and processes changes to the equipment configuration, e.g., an addition, removal, activation, deactivation, or repositioning of one or more server devices, in order to map changes in environmental conditions. e.g., due to changes in airflow and/or thermal output.

Referring now to FIG. 3D, the method 300 may include an additional step 320. At the step 320, the system receives and processes changes to the CRAC configuration, e.g., an addition, removal, activation, deactivation, or repositioning of one or more CRAC units, in order to map changes in environmental conditions, e.g., due to changes in cooling capacity and/or output and return air flow patterns.

Referring now to FIG. 3E, the method may include an additional step 322. At the step 322, the system receives ambient climate information, e.g., temperature and/or humidity proximate to but external to the room (e.g., outdoor air temperature and/or humidity). For example, the environmental model may additionally account for outdoor conditions in the mapping of airflow and/or temperature within the room or within zones thereof.

### CONCLUSION

It is contemplated that embodiments of the inventive concepts disclosed herein may have numerous advantages. For example, as noted above, the environmental model may self-maintain, adjusting to routine changes in temperature or humidity without outside intervention. The model may identify and/or attempt to correct problematic areas within the data center that might otherwise require a dense network of sensors to detect. Further, the environmental model may self-adjust to structural or physical changes within the data center, gradually adjusting the CRAC units to the new environmental conditions. Further still, the system may proactively model airflow and temperature within the data center based on hypothetical changes, providing insight on optimal equipment and/or CRAC configurations without the need to setup and test such configurations.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary. Those skilled in the art will recognize that optical aspects of implementations will typically employ optically-oriented hardware, software, and or firmware.

The foregoing detailed description has set forth various embodiments of the devices and/or processes via the use of block diagrams, flowcharts, and/or examples. Insofar as such block diagrams, flowcharts, and/or examples contain one or more functions and/or operations, it will be understood by those within the art that each function and/or operation within such block diagrams, flowcharts, or examples can be implemented, individually and/or collectively, by a wide range of hardware, software, firmware, or virtually any combination thereof. In one embodiment, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the embodiments disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this disclosure. In addition, those skilled in the art will appreciate that the mechanisms of the subject matter described herein are capable of being distributed as a program product in a variety of forms, and that an illustrative embodiment of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the scope of the subject matter described herein. Furthermore, it is to be understood that the invention is defined by the appended claims.

## Claims

1. A computer-assisted method for thermal management within an environment, the method comprising:
receiving, via a controller, a dimension set including one or more physical dimensions of an environment;
receiving, via the controller, an equipment configuration corresponding to a plurality of information technology "IT" devices, each IT device having a position within the environment and a thermal output;
receiving, via the controller, a computer room air conditioner "CRAC" configuration corresponding to a plurality of CRAC units, each CRAC unit having at least one CRAC setpoint and a position within the environment, each CRAC unit configured to:
output chilled air into the environment according to the at least one CRAC setpoint;
receive return air having a return air temperature; and
chill the return air according to the at least one CRAC setpoint;
receiving, via the controller, at least one policy set defining one or more zones within the environment, and defining one or more required environmental conditions corresponding to each zone;
generating, via the controller and based on the dimension set, the equipment configuration, and the CRAC configuration, an environmental model corresponding to one or more current environmental conditions within the environment;
inferring, via the controller and based on the environmental model, one or more current environmental conditions associated with at least one zone defined by the policy set;
comparing, via the controller, the one or more inferred current environmental conditions associated with the at least one zone to the one or more required environmental conditions corresponding to the at least one zone;
and
adjusting, via the controller and based on the comparing, the at least one CRAC setpoint of one or more CRAC units of the plurality of CRAC units.

2. The computer-assisted method of Claim 1, wherein generating an environmental model corresponding to one or more current environmental conditions within the environment includes:
verifying the environmental model via one or more temperature or humidity sensors within the environment.

3. The computer-assisted method of Claim 1 or 2, wherein generating an environmental model corresponding to one or more current environmental conditions within the environment includes:
generating the environmental model according to lattice Boltzmann methods.

4. The computer-assisted method of any preceding Claim, wherein comparing the one or more inferred current environmental conditions associated with the at least one zone to the one or more required environmental conditions corresponding to the at least one zone includes:
when the inferred current environmental conditions associated with the at least one zone deviate to at least a threshold level from the one or more required environmental conditions corresponding to the at least one zone, generating an alert.

5. The computer-assisted method of any preceding Claim , wherein:
the CRAC configuration is a hypothetical CRAC configuration;
and
wherein inferring, based on the environmental model, one or more current environmental conditions associated with at least one zone defined by the policy set includes:
inferring one or more hypothetical environmental conditions associated with at least one zone based on the hypothetical CRAC configuration.

6. The computer-assisted method of any preceding Claim , further comprising:
receiving, via the controller, at least one equipment change associated with the equipment configuration, the at least one equipment change including one or more of:
an addition of an IT device to the environment;
a removal of an IT device from the environment;
an activation of an IT device within the environment;
a deactivation of an IT device within the environment;
or
a repositioning of an IT device within the environment, and/or further comprising:
receiving, via the controller, at least one CRAC change associated with the CRAC configuration, the at least one CRAC change including one or more of:
an addition of a CRAC unit to the environment;
a removal of a CRAC unit from the environment;
an activation of a CRAC unit within the environment;
a deactivation of a CRAC unit within the environment; or
a repositioning of a CRAC unit within the environment.

7. The computer-assisted method of any preceding Claim , wherein:
the one or more required environmental conditions include at least one of a required temperature range or a required airflow rate;
and
the one or more inferred current environmental conditions include at least one of an inferred temperature, an inferred humidity, or an inferred airflow rate.

8. The computer-assisted method of any preceding Claim , wherein the equipment configuration includes at least one obstacle capable of obstructing an airflow through the environment, each obstacle having a position within the environment, and/or wherein each CRAC setpoint is associated with at least one of an output air temperature and an output flow rate.

9. The computer-assisted method of any preceding Claim , wherein:
at least one CRAC unit of the plurality of CRAC units includes one or more sensors configured for sensing at least one of:
an output air temperature of the chilled air leaving the CRAC unit;
a return air temperature of the return air; or
a fan setting of the CRAC unit, and optionally
wherein the CRAC configuration is updated according to the sensed output air temperature, return air temperature, or fan setting.

10. The computer-assisted method of any preceding Claim , wherein:
at least one IT device includes a sensor configured to sense the thermal output of the IT device;
and
the equipment configuration is updated according to the at least one sensed thermal output.

11. The computer-assisted method of any preceding Claim , further comprising:
receiving one or more of an ambient temperature or an ambient humidity external to the environment;
and
wherein generating an environmental model corresponding to one or more current environmental conditions within the environment includes:
generating the environmental model based on the dimension set, the equipment configuration, the CRAC configuration, and the ambient temperature or ambient humidity, and optionally
wherein the ambient temperature or ambient humidity include at least one of:
an estimated ambient temperature or estimated ambient humidity provided by at least one of the dimension set, the policy set, or the equipment configuration;
or
an ambient temperature or ambient humidity sensed by at least one sensor external to and proximate to the environment.

12. The computer-assisted method of any preceding Claim, wherein the controller includes a CRAC control loop configured for adjustment of each CRAC setpoint of the plurality of CRAC units.

13. A system for thermal management of an environment, the system comprising:
one or more processors; and
a memory configured for storage of:
a dimension set including one or more physical dimensions of an environment;
an equipment configuration corresponding to an arrangement of a plurality of information technology (IT) devices, each IT device having a position within the environment and a thermal output;
a computer room air conditioner (CRAC) configuration corresponding to a plurality of CRAC units, each CRAC unit having at least one CRAC setpoint and a position within the environment, each CRAC unit configured to:
output chilled air into the environment according to the at least one CRAC setpoint;
receive return air having a return air temperature; and
chill the return air according to the at least one CRAC setpoint;
at least one policy set defining one or more zones within the environment, and defining one or more required environmental conditions corresponding to each zone;
and
encoded instructions executable by the one or more processors, the one or more processors configurable by the encoded instructions for:
generating, based on the dimension set, the equipment configuration, and the CRAC configuration, an environmental model corresponding to one or more current environmental conditions within the environment;
inferring, based on the environmental model, one or more current environmental conditions associated with at least one zone defined by the policy set;
comparing the one or more inferred current environmental conditions associated with at least one zone to the one or
more required environmental conditions corresponding to that zone;
and
adjusting, based on the comparing, the at least one CRAC setpoint of one or more CRAC units of the plurality of CRAC units.

14. The system of Claim 13, wherein the one or more processors are configurable for generating the environmental model according to lattice Boltzmann methods.

15. The system of Claim 13 or 14, further comprising:
at least one calibration sensor disposed within the environment, the at least one calibration sensor configured for verification of the environmental model by sensing at least one of an air temperature or a humidity within the environment, and/or
further comprising:
at least one external sensor disposed proximate to and external to the environment, the at least one external sensor configured for verification of the environmental model by sensing at least one of an external air temperature or an external humidity.
